# EUROPÄISCHE PATENTANMELDUNG

(11) **EP 4 575 875 A1**
(43) Veröffentlichungstag der Anmeldung: **25.06.2025**
(21) Anmeldenummer: 23217568.7
(22) Anmeldetag: 18.12.2023
(51) Int. Cl.: G06F 30/20, G06F 30/27, G06Q 10/04

(54) **COMPUTERIMPLEMENTIERTES VERFAHREN ZUM STEUERN EINER SIMULATIONSVORRICHTUNG MITTELS VERÄNDERUNGSVORSCHLÄGEN**

(71) Anmelder: dSPACE GmbH, 33102 Paderborn (DE)
(72) Erfinder: Miller, Eduard, 33102 Paderborn (DE); Bannenberg, Sebastian, 33102 Paderborn (DE); Selbstreich, Eugen, 33102 Paderborn (DE)

(57) **Zusammenfassung**

Die Erfindung betrifft ein computerimplementiertes Verfahren zum Generieren eines Veränderungsvorschlages (10) für wenigstens einen Simulationslauf (12) einer eine Vielzahl an Simulationsläufen (12) umfassende Simulation (14), mit den Schritten
- Empfangen eines oder mehrerer Simulationslaufresultate (16) eines oder mehrerer beendeter Simulationsläufe (12) der Simulation (14),
- Vorhersagen wenigstens eines Simulationslaufresultates (20) eines noch nicht beendeten Simulationslaufes (12) der Simulation (14) unter Berücksichtigung der empfangenen Simulationslaufresultate (16), und
- Generieren des Veränderungsvorschlages (10) für bisher noch nicht beendete Simulationsläufe (12) der Simulation (14), unter Berücksichtigung des wenigstens einen vorhergesagten Simulationslaufresultates (20).

Weiterhin betrifft die Erfindung eine Vorrichtung zur Datenverarbeitung umfassend Mittel zur Ausführung des obigen Verfahrens, ein Computerprogrammprodukt und einen entsprechenden computerlesbaren Datenträger.

## Beschreibung

Die Erfindung betrifft ein computerimplementiertes Verfahren zum Generieren eines Veränderungsvorschlages für wenigstens einen Simulationslauf einer eine Vielzahl an Simulationsläufen umfassende Simulation.

Weiterhin betrifft die Erfindung eine Vorrichtung zur Datenverarbeitung umfassend Mittel zur Ausführung des obigen Verfahrens.

Weiterhin betrifft die Erfindung ein Computerprogrammprodukt, umfassend Befehle, die bei der Ausführung des Programms durch einen Computer diesen veranlassen, das obige Verfahren auszuführen.

Ferner betrifft die Erfindung einen computerlesbaren Datenträger, auf dem das obige Computerprogrammprodukt gespeichert ist.

Fahrassistenzsysteme wie z.B. ein adaptiver Geschwindigkeitsregler und/oder Funktionen für das hochautomatisierte bzw. autonome Fahren können mithilfe diverser Überprüfungsmethoden verifiziert bzw. validiert werden. Beispielsweise kann für Funktionstests von Software von elektronischen Steuergeräten (ECUs) grundsätzlich Hardware in Form des Steuergerätes oder in Form eines Steuergeräteprototyps eingesetzt und die Steuerungssoftware im realen Fahrversuch getestet werden. Bei solchen Tests ist allerdings, neben den hohen Kosten und dem sehr hohen Zeitaufwand, die fehlende Reproduzierbarkeit, aufgrund der komplexen Umweltbedingungen, problematisch.

Weiterhin bieten sich sogenannte Hardware in the Loop (HiL) Tests an, bei dem das ECU über Ein- und Ausgänge an einen HiL-Simulator angeschlossen wird, wobei der HiL-Simulator die reale Umgebung nachbildet. Der HiL-Simulator emuliert die elektrischen Signale von Sensoren und Aktoren, die vom ECU gelesen werden. Beispielsweise werden bei einem HiL-Test eines Verbrennungsmotors die Signale von Kurbel- und Nockenwellensensoren von einer Angular Processing Unit (APU) erzeugt, die Teil der Hardware des HiL-Simulators ist. Das ECU wiederum generiert auf Basis dieser Signale mittels der Steuerungssoftware Sensor- und/oder Aktorsteuersignal, die wiederum zu einer Änderung der elektrischen Signale im HiL-Simulator führen. Die Strecke, die im realen Fahrversuch als Versuchsstrecke abgefahren und so unterschiedliche elektrische Signale für das Steuergerät generieren würde, wird innerhalb der HiL-Simulation als Streckenmodell abgebildet. Um einen HiL-Test durchzuführen, muss allerdings die Entwicklung eines ECUs schon relativ weit fortgeschritten sein, da das ECU als Hardware an den HiL-Simulator angeschlossen wird.

Um frühere Test der Steuerungssoftware zu ermöglichen, beispielsweise zu einem Entwicklungszeitpunkt, zu dem noch keine Hardware vorliegt, sind Hardwareunabhängige Softwaretests erforderlich. Hierfür können virtuelle Steuergeräte, auch V-ECUs genannt, verwendet werden. Mittels eines virtuellen Steuergerätes wird in einem Simulationsszenario ein echtes Steuergerät emuliert. Um möglichst realitätsnahe virtuelle Steuergeräte zu erstellen, kann ein virtuelles Steuergerät auf Basis der Steuerungssoftware des echten Steuergerätes erstellt werden. Dabei müssen natürlich einige Komponenten der Steuerungssoftware des echten Steuergerätes an die virtuelle Umgebung der Simulationsplattform angepasst werden. Dieses Vorgehen hat in der Regel das Ziel ein reales Steuergerät möglichst gut zu simulieren.

Das Verlegen der virtuellen Tests in immer frühere Entwicklungsphasen führt allerdings zu veränderten Anforderungen, bei denen nicht mehr das möglichst gute Nachahmen des Verhaltens eines spezifischen Steuergerätes im Vordergrund steht, sondern bei denen verschiedenste Anwendungen in einer flexiblen und hochmodularen Umgebung getestet werden sollen. Dies erfolgt in der Regel durch reproduzierbare, deterministische Testfahrten mit einem virtuellen Fahrzeug in einer virtuellen Umgebung. Das Fahrzeug, die Umgebung und die Tests - also die Verkehrsszenarien - können dabei alle frei vom Nutzer definiert werden. Auf diese Art und Weise können unter anderem neue Algorithmen für die Fahrzeugsteuerung in virtualisierten, autonomen Fahrzeugen erprobt werden.

Ein mögliches zu betrachtendes Verkehrsszenario ist beispielsweise ein sogenanntes Cut-In-Szenario. Das Cut-In-Szenario bezeichnet eine Verkehrssituation, bei welcher ein hochautomatisiertes bzw. autonomes Fahrzeug - im folgenden Ego-Fahrzeug genannt - in einer vorgegebenen Fahrspur fährt. Ein anderes Fahrzeug schert in einem bestimmten Abstand zum Ego-Fahrzeug und mit gegenüber dem Ego-Fahrzeug verringerter Geschwindigkeit von einer weiteren Fahrspur in die Fahrspur des Ego-Fahrzeugs ein.

Bei dem Verkehrsszenario ist in der Regel vorgesehen, dass die Geschwindigkeit des Ego-Fahrzeugs und des weiteren Fahrzeugs zunächst konstant ist. Da die Geschwindigkeit des Ego-Fahrzeugs allerdings höher ist als die des weiteren Fahrzeugs, muss das Ego-Fahrzeug abgebremst werden, um eine Kollision mit dem weiteren Fahrzeug zu vermeiden.

Das Verkehrsszenario kann mit unterschiedlichen Parameterwerten simuliert werden, beispielsweise verschiedene Abstände des Ego-Fahrzeugs und des weiteren Fahrzeuges zueinander beim Einscheren, oder unterschiedliche Geschwindigkeitsdifferenzen des Ego-Fahrzeuges zum weiteren Fahrzeug. Um einen möglichst hohen Erkenntnisgewinn aus der Simulation zu erlangen, werden also viele verschiedene Simulationsläufe in dem möglichen Parameterraum durchgeführt. Komplexe Verkehrsszenarien weisen viele Parameter und somit einen sehr großen abzudeckenden Parameterraum auf, so dass zur Abdeckung des Testraums typischerweise über Hunderttausend Simulationsläufe durchzuführen sind. Entsprechend sind solche Simulationen ressourcen- und/oder zeitintensiv.

Davon ausgehend ist es Aufgabe der Erfindung komplexe Verkehrsszenarien ressourcenschonend und/oder in kurzer Zeit zu simulieren. Bevorzugt ist es Aufgabe der Erfindung den Parameterraum bei der Simulation einzugrenzen.

Diese Aufgabe wird durch die Merkmale der unabhängigen Patentansprüche gelöst. Bevorzugte Weiterbildungen finden sich in den Unteransprüchen.

Erfindungsgemäß wird also ein computerimplementiertes Verfahren zum Generieren eines Veränderungsvorschlages für wenigstens einen Simulationslauf einer eine Vielzahl an Simulationsläufen umfassende Simulation bereitgestellt, mit den Schritten
- Empfangen eines oder mehrerer Simulationslaufresultate eines oder mehrerer beendeter Simulationsläufe der Simulation,
- Vorhersagen wenigstens eines Simulationslaufresultates eines noch nicht beendeten Simulationslaufes der Simulation unter Berücksichtigung der empfangenen Simulationslaufresultate, und
- Generieren des Veränderungsvorschlages für bisher noch nicht beendete Simulationsläufe der Simulation, unter Berücksichtigung des wenigstens einen vorhergesagten Simulationslaufresultates.

Ein Aspekt der Erfindung ist also, dass auf Basis von empfangenen Simulationslaufresultaten von bisher schon durchgeführten Simulationsläufen eine Vorhersage über Simulationslaufresultate von bisher noch nicht beendeten Simulationsläufe getroffen wird, und unter Berücksichtigung dieser vorhergesagten Simulationslaufresultate der Veränderungsvorschlag generiert wird. Entsprechend können durch die Vorhersage die Ergebnisse frühzeitig - also bevorzugt vor der Durchführung und der Beendigung aller Simulationsläufe der Simulation - ausgewertet werden, was ressourcenschonen ist und zu Kosteneinsparungen führt. In anderen Worten wird also parallel zur durchzuführenden Simulation mit der Vielzahl an Simulationsläufen das Verfahren zum Generieren des Veränderungsvorschlages für wenigstens einen Simulationslauf durchgeführt, um frühzeitig Vorhersagen über die Simulationslaufresultate treffen zu können und um bevorzugt noch bevor alle Simulationsläufe der Simulation beendet sind, entsprechende Veränderungsvorschläge für die noch nicht beendeten Simulationsläufe umsetzen zu können.

Die Simulation weist die Vielzahl an Simulationsläufe auf, typischerweise in der Größenordnung von 100 000 Simulationsläufen. Wenn ein Simulationslauf beendet ist, liegt auch das Simulationslaufresultat des entsprechenden Simulationslaufes vor. Bevorzugt weisen die Vielzahl der Simulationsläufe unterschiedliche Parameter zueinander auf. Derart decken die Simulationsläufe den möglichen Parameterraum der Simulation ab. Noch nicht beendete Simulationsläufe sind Simulationsläufe, die noch nicht gestartete wurden oder Simulationsläufe, die zwar schon gestartet aber noch nicht beendet wurden. Für noch nicht beendete Simulationsläufe liegt also kein Simulationslaufresultat aus der Simulation vor.

Gemäß einer bevorzugten Weiterbildung der Erfindung ist vorgesehen, dass das Verfahren den Schritt Verändern eines oder mehrerer bisher noch nicht beendeter Simulationsläufe der Simulation unter Berücksichtigung des generierten Veränderungsvorschlages umfasst. Bevorzugt werden also auf Basis des Veränderungsvorschlages automatisiert Änderungen an den bisher noch nicht beendeten Simulationsläufen durchgeführt. Derart können ohne Interaktion mit einem Nutzer Kosten eingespart werden und/oder Ressourcen geschont werden.

In diesem Zusammenhang ist gemäß einer weiteren bevorzugten Weiterbildung der Erfindung vorgesehen, dass der generierte Veränderungsvorschlag ein Abbrechen noch nicht beendeter Simulationsläufe, ein Nichtdurchführen noch nicht gestarteter Simulationsläufe, und/oder ein Anpassen von Simulationsparametern bei noch nicht gestarteten Simulationsläufen umfasst. Durch das Abbrechen noch nicht beendeter Simulationsläufe, sowie durch das Nichtdurchführen noch nicht gestarteter Simulationsläufe wird die Anzahl an Simulationsläufen reduziert, was Ressourcen, Zeit und Kosten spart. Es werden also Simulationsläufe, bei denen aufgrund der vorhergesagten Simulationslaufresultate zu erwarten ist, dass sie keinen Erkenntnisgewinn bringen, gar nicht erst durchgeführt. Durch das Anpassen von Simulationsparametern bei noch nicht gestarteten Simulationsläufen kann die Simulation in dem für aufgrund der vorhergesagten Simulationslaufresultate als sinnvoll erwiesenen Parameterraum eingegrenzt werden. Entsprechend steigt der Erkenntnisgewinn aus den durchgeführten Simulationen.

Gemäß einer weiteren bevorzugten Weiterbildung der Erfindung ist vorgesehen, dass das Verfahren den zusätzlichen Schritt Generieren eines Simulationslaufresultates der Simulation durch Durchführen und Beenden eines Simulationslaufes der Simulation umfasst. Die im ersten Schritt des Verfahrens empfangenen Simulationslaufresultate stammen bevorzugt aus genau jener Simulation zu der parallel das Verfahren zum Generieren des Veränderungsvorschlages durchgeführt wird. Dies führt zu besonders guten Vorhersagen.

Gemäß einer weiteren bevorzugten Weiterbildung des Verfahrens ist vorgesehen, dass das Verfahren den Schritt Trainieren eines Ersatzmodelles der Simulation mittels den empfangenen Simulationslaufresultaten umfasst. In anderen Worten werden die Vorhersagen also durch ein Ersatzmodell generiert, das mit den Empfangenen Simulationslaufresultaten trainiert wird. Dies führt vorteilhafterweise dazu, dass die die Vorhersagen des Ersatzmodells durch das Training mit den empfangene Simulationslaufresultaten stetig besser werden.

In diesem Zusammenhang ist weiterhin gemäß einer bevorzugten Weiterbildung der Erfindung vorgesehen, dass das Verfahren den Schritt Bestimmen einer Güte und/oder eines Fehlers des Ersatzmodelles der Simulation, durch Vergleichen von vorhergesagten Simulationslaufresultaten des Ersatzmodelles mit den empfangenen Simulationslaufresultaten umfasst. Dies erlaubt, die Vorhersagegenauigkeit des Ersatzmodelles laufend einzuschätzen und bevorzugt erst bei Überschreiten einer vordefinierten Güte und/oder bei Unterschreiten eines vordefinierten Fehlers des Ersatzmodelles, die Veränderungsvorschläge für bisher noch nicht beendete Simulationsläufe der Simulation zu generieren und/oder die generierten Veränderungsvorschläge durch bevorzugt automatisiertes Verändern bisher noch nicht beendeter Simulationsläufe umzusetzen.

Gemäß einer weiteren Weiterbildung des Verfahrens wird bevorzugt der Schritt des Vorhersagens des wenigstens einen Simulationslaufresultates eines noch nicht beendeten Simulationslaufes der Simulation unter Berücksichtigung der empfangenen Simulationslaufresultate, mittels des Ersatzmodells der Simulation durchgeführt, und das Ersatzmodell weist gegenüber einem Simulationsmodell der Simulation einen verringerten Ressourcenbedarf und/oder eine verkürzte Laufzeit auf. In anderen Worten ist das Ersatzmodell im Vergleich zum Simulationsmodell also ressourcenschonender und/oder effizienter, wodurch das Vorhersagen der Simulationslaufresultate mittels des Ersatzmodelles im vergleich zum Ermitteln der Simulationslaufresultate mittels des Simulationsmodelles der Simulation schneller und/oder weniger ressourcenintensiv ist.

In Bezug zum Ersatzmodell ist gemäß einer weiteren bevorzugten Weiterbildung vorgesehen, dass das Ersatzmodell ein neuronales Netzwerk und/oder eine radiale Basisfunktion umfasst. Insbesondere neuronale Netzwerke und/oder Linearkombinationen von radialen Basisfunktionen eignen sich besonders gut zur Approximation von Funktionen - vorliegend also der Simulation mittels des Simulationsmodelles.

Gemäß einer weiteren Weiterbildung der Erfindung ist das vorhergesagte Simulationslaufresultat bevorzugt ausgewählt aus der Gruppe umfassend KPI-Werte, Observer Zuschläge, Verdikts. In anderen Worten wird bevorzugt mittels des Ersatzmodelles KPI Werte, Observer Zuschläge und/oder Verdikts als Simulationslaufresultate vorhergesagt. Unter KPI-Werten werden vorliegend *Key Performance Indicators,* also wesentlicher Leistungsindikatoren der Simulation verstanden. Beispielweise könnte eine KPI die von einem Fahrzeug in einer Simulation zurückgelegte Strecke oder auch die Anzahl der Kollisionen von Fahrzeugen im Verhältnis zur zurückgelegten Strecke sein. Oberserver Zuschläge erlauben eine Aussage über die dynamische Antwort des Simulationsmodelles und ermöglichen, dass das Auftreten einer durch einen Observer definierten Situation beispielsweise die Unterschreitung eines Mindestabstandes zwischen zwei Fahrzeugen erkannt wird. Bei einem Verdikt handelt es sich vorliegend um eine Variable, die die Simulation beurteilt und Werte wie beispielsweise "fehlerhaft", "ergebnislos", "bestanden" (engl. "passed"), "durchgefallen" (engl. "failed") annehmen kann.

Gemäß einer weiteren bevorzugten Weiterbildung der Erfindung ist vorgesehen, dass das Verfahren den Schritt Auswerten von mehreren vorhergesagten Simulationslaufresultaten umfasst, und wobei das Auswerten das Durchführen einer Schwellwertanalyse, das Bestimmen eines Trends und/oder das Bestimmen einer passed/failed-Rate umfasst. Auf Basis dieser Auswertungen lassen sich besonders gut Veränderungsvorschläge generieren und/oder unter Berücksichtigung des generierten Veränderungsvorschlages Änderungen an einem oder mehreren bisher noch nicht beendeten Simulationsläufe der Simulation durchführen. Zudem kann vorgesehen sein, dass den Verfahren den Schritt Auswerten von mehreren empfangenen Simulationslaufresultaten und von mehreren vorhergesagten Simulationslaufresultaten umfasst. In anderen Worten können also die empfangenen Simulationslaufresultate in die Auswertung - sprich in das Bestimmen des Trends, und/oder der passed/failed-Rate - einbezogen werden.

Weitere technische Merkmale und Vorteile ergeben sich für den Fachmann aus der nachfolgenden Beschreibung einer Vorrichtung zur Datenverarbeitung, eines Computerprogrammproduktes und/oder eines computerlesbaren Datenträgers, sowie aus dem Ausführungsbeispiel.

Die Aufgabe wird auch gelöst durch eine Vorrichtung zur Datenverarbeitung umfassend Mittel zur Ausführung des oben beschriebenen Verfahrens. Bevorzugt handelt es sich bei der Vorrichtung zur Datenverarbeitung um eine serverbasierte Vorrichtung. Dies erlaubt, dass der Nutzer selbst keine Hardware-Ressourcen zum Durchführen des Verfahrens zum Generieren des Veränderungsvorschlages für wenigstens einen Simulationslauf der eine Vielzahl an Simulationsläufen umfassenden Simulation vorhalten muss, sondern das Verfahren dem Nutzer auf einem Server zur Verfügung gestellt wird.

Weiterhin betrifft die Erfindung ein Computerprogrammprodukt, umfassend Befehle, die bei der Ausführung des Programms durch einen Computer diesen veranlassen, das obige Verfahren auszuführen.

Zudem betrifft die Erfindung einen computerlesbaren Datenträger, auf dem das obige Computerprogrammprodukt gespeichert ist. Bevorzugt sind die Befehle auf dem computerlesbaren Datenträger eingebettet, und die Befehle bewirken, wenn sie von einem Prozessor des Computers ausgeführt werden, dass der Prozessor das Verfahren zum Generieren des Veränderungsvorschlages für wenigstens einen Simulationslauf der eine Vielzahl an Simulationsläufen umfassende Simulation auszuführt.

Die technischen Vorteile und Effekte der Vorrichtung zur Datenverarbeitung, des Computerprogrammproduktes und des computerlesbaren Datenträgers ergeben sich für den Fachmann durch die Beschreibung des Verfahrens zum Generieren des Veränderungsvorschlages, sowie durch das nachfolgend beschriebene Ausführungsbeispiel.

Die Erfindung wird nachfolgend unter Bezugnahme auf die Zeichnung näher erläutert. Die dargestellte Ausführungsform ist stark schematisiert, d.h. Abstände, Dimensionen und Abmessungen sind nicht maßstäblich und weisen, sofern nicht anders angegeben, auch keine ableitbaren geometrischen Relationen zueinander auf.

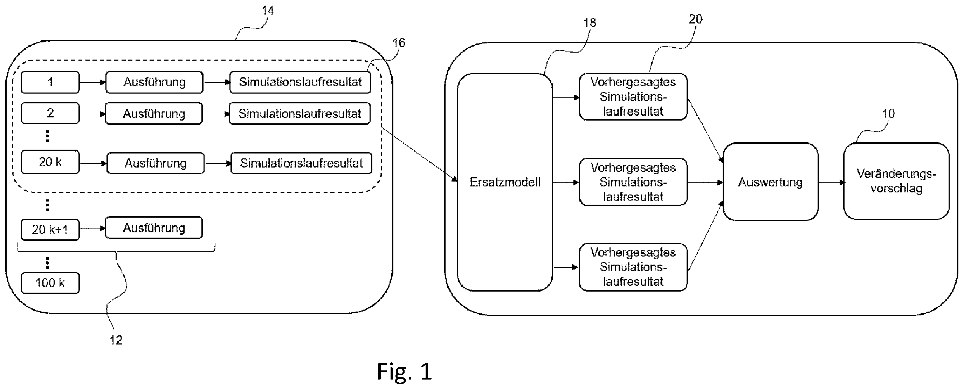

In der Zeichnung zeigt
- Fig. 1: schematisch ein Diagramm zur Illustration eines Verfahrens zum Generieren eines Veränderungsvorschlages, gemäß einem bevorzugten Ausführungsbeispiel der Erfindung.

Figur 1 zeigt schematisch ein Diagramm zur Illustration eines Verfahrens zum Generieren eines Veränderungsvorschlages 10 für wenigstens einen Simulationslauf 12 einer eine Vielzahl an Simulationsläufen 12 umfassende Simulation 14, gemäß einem bevorzugten Ausführungsbeispiel der Erfindung.

In diesem Ausführungsbeispiel soll eine Simulation 14 mit 100 000 Simulationsläufen 12 durchgeführt werden. Nachdem ein Nutzer Simulationsparameter der Simulationsläufe 12 festgelegt hat, wird die Simulation 14 gestartet und mittels eines Simulationsmodells der Simulation 14 werden Simulationslaufresultate 16 der einzelnen Simulationsläufe 12 ermittelt. Die Figur 1 stellt die Situation zu einem Zeitpunkt dar, bei dem die ersten Simulationsläufe 12 mit dem Simulationsmodell durchgeführt und beendet wurden und entsprechende Simulationslaufresultate 16 vorliegen. Konkret wurden 20 000 Simulationsläufe 12 der Simulation 14 durchgeführt und es liegen entsprechend 20 000 Simulationslaufresultate 16 vor.

Im Verfahren zum Generieren des Veränderungsvorschlages 10 für wenigstens einen Simulationslauf 12 der Vielzahl an Simulationsläufen 12, werden in einem ersten Schritt die Simulationslaufresultate 16 der beendeten Simulationsläufe 12 der Simulation 14 empfangen. Mit diesen empfangenen Simulationslaufresultaten 16 wird nun ein Ersatzmodell 18 trainiert. Das Ersatzmodell 18 dient dem Zweck wenigstens ein Simulationslaufresultat 16 vorherzusagen. Bei dem Ersatzmodell 18 handelt es sich vorliegend um ein neuronales Netzwerk. Mit dem Ersatzmodell 18 werden im folgenden Simulationslaufresultate 20 von noch nicht beendeten Simulationsläufen 12 der Simulation 14 unter Berücksichtigung der empfangenen Simulationslaufresultate 16 vorhergesagt. Bei den vorhergesagten Simulationslaufresultaten 20 handelt es sich in diesem Ausführungsbeispiel um KPI-Werte, Observer Zuschläge, und Verdikts. Um die Güte des Ersatzmodells 18 zu bewerten, wird zudem kontinuierlich der Fehler des Ersatzmodells 18 bestimmt. Bei Unterschreiten eines vordefinierten Schwellwertes für den Fehler des Ersatzmodelles 18 wird unter Berücksichtigung der bisher vorhergesagten Simulationslaufresultate 20 ein Veränderungsvorschlag 10 für bisher noch nicht beendete Simulationsläufe 12 der Simulation 14 generiert. Dazu werden die vorhergesagten Simulationslaufresultate 20 sowie die empfangenen Simulationslaufresultate 16 ausgewertet. In diesem Ausführungsbeispiel werden im Rahmen der Auswertung eine Schwellenwertanalyse, eine Trendbeobachtung und eine Betrachtung der passed/failed-Rate durchgeführt.

Der Veränderungsvorschlag 10 umfasst in diesem Ausführungsbeispiel Abbrechen noch nicht beendeter Simulationsläufe 12 und ein Nichtdurchführen noch nicht gestarteter Simulationsläufe 12. Zudem werden in diesem Ausführungsbeispiel die Veränderungsvorschläge 10 automatisiert umgesetzt. Entsprechend umfasst das Verfahren vorliegend auch das Verändern mehrerer bisher noch nicht beendeter Simulationsläufe 12 der Simulation 14 unter Berücksichtigung des generierten Veränderungsvorschlages 10. In diesem Ausführungsbeispiel führt dies aufgrund der vorhergesagten Simulationslaufresultate 20 zum Abbruch aller noch nicht beendeter Simulationsläufe 12 und zum Nichtdurchführen aller noch nicht gestarteter Simulationsläufe 12. Somit werden 80 000 Simulationsläufe 12 weniger durchgeführt als ursprünglich geplant und entsprechend 80 % der Kosten eingespart.

### Bezugszeichenliste

- 10: Veränderungsvorschlag
- 12: Simulationslauf
- 14: Simulation
- 16: Simulationslaufresultat
- 18: Ersatzmodell
- 20: vorhergesagtes Simulationslaufresultat

## Patentansprüche

1. Computerimplementiertes Verfahren zum Generieren eines Veränderungsvorschlages (10) für wenigstens einen Simulationslauf (12) einer eine Vielzahl an Simulationsläufen (12) umfassende Simulation (14), mit den Schritten
- Empfangen eines oder mehrerer Simulationslaufresultate (16) eines oder mehrerer beendeter Simulationsläufe (12) der Simulation (14),
- Vorhersagen wenigstens eines Simulationslaufresultates (20) eines noch nicht beendeten Simulationslaufes (12) der Simulation (14) unter Berücksichtigung der empfangenen Simulationslaufresultate (16), und
- Generieren des Veränderungsvorschlages (10) für bisher noch nicht beendete Simulationsläufe (12) der Simulation (14), unter Berücksichtigung des wenigstens einen vorhergesagten Simulationslaufresultates (20).

2. Verfahren nach Anspruch 1, wobei das Verfahren den Schritt Verändern eines oder mehrerer bisher noch nicht beendeter Simulationsläufe (12) der Simulation (14) unter Berücksichtigung des generierten Veränderungsvorschlages (10) umfasst.

3. Verfahren nach einem der vorherigen Ansprüche, wobei der generierte Veränderungsvorschlag (10) ein Abbrechen noch nicht beendeter Simulationsläufe (12), ein Nichtdurchführen noch nicht gestarteter Simulationsläufe (12), und/oder ein Anpassen von Simulationsparametern bei noch nicht gestarteten Simulationsläufen (12) umfasst.

4. Verfahren nach einem der vorherigen Ansprüche, wobei das Verfahren den zusätzlichen Schritt Generieren eines Simulationslaufresultates (16) der Simulation (14) durch Durchführen und Beenden eines Simulationslaufes (12) der Simulation (14) umfasst.

5. Verfahren nach einem der vorherigen Ansprüche, wobei das Verfahren den Schritt Trainieren eines Ersatzmodelles (18) der Simulation (14) mittels den empfangenen Simulationslaufresultaten (16) umfasst.

6. Verfahren nach dem vorhergehenden Anspruch, wobei das Verfahren den Schritt Bestimmen einer Güte und/oder eines Fehlers des Ersatzmodelles (18) der Simulation (14), durch Vergleichen von vorhergesagten Simulationslaufresultaten (20) des Ersatzmodelles (18) mit den empfangenen Simulationslaufresultaten (16) umfasst.

7. Verfahren nach einem der vorherigen Ansprüche, wobei der Schritt des Vorhersagens des wenigstens einen Simulationslaufresultates (20) eines noch nicht beendeten Simulationslaufes (12) der Simulation (14) unter Berücksichtigung der empfangenen Simulationslaufresultate (16), mittels eines Ersatzmodells (18) der Simulation (14) durchgeführt wird, und wobei das Ersatzmodell (18) gegenüber einem Simulationsmodell der Simulation (14) einen verringerten Ressourcenbedarf aufweist und/oder eine verkürzte Laufzeit aufweist.

8. Verfahren nach einem der Ansprüche 5 bis 7, wobei das Ersatzmodell (18) ein neuronales Netzwerk und/oder eine radiale Basisfunktion umfasst.

9. Verfahren nach einem der vorherigen Ansprüche, wobei das vorhergesagte Simulationslaufresultat (20) ausgewählt ist aus der Gruppe umfassend KPI-Werte, Observer Zuschläge, Verdikts.

10. Verfahren nach einem der vorhergehenden Ansprüche, wobei das Verfahren den Schritt Auswerten von mehreren vorhergesagten Simulationslaufresultaten (20) umfasst, und wobei das Auswerten das Durchführen einer Schwellwertanalyse, das Bestimmen eines Trends und/oder das Bestimmen einer passed/failed-Rate umfasst.

11. Vorrichtung zur Datenverarbeitung umfassend Mittel zur Ausführung des Verfahrens nach einem der Ansprüche 1 bis 10.

12. Computerprogrammprodukt, umfassend Befehle, die bei der Ausführung des Programms durch einen Computer diesen veranlassen, das Verfahren nach einem der Ansprüche 1 bis 10 auszuführen.

13. Computerlesbarer Datenträger, auf dem das Computerprogrammprodukt nach dem vorhergehenden Anspruch gespeichert ist.
